# EUROPÄISCHE PATENTSCHRIFT

(11) **EP 0 321 806 B1**
(45) Veröffentlichungstag und Bekanntmachung des Hinweises auf die Patenterteilung: **10.03.1993**
(21) Anmeldenummer: 88120648.6
(22) Anmeldetag: 09.12.1988
(51) Int. Cl.: H03L 7/08, G01R 23/00

(54) **Frequenzdiskriminator für einen digitalen Phasenregelkreis**
Frequency discriminator for a digital phase-locked loop
Discriminateur de fréquence pour une boucle de verrouillage de phase

(30) Priorität: 17.12.1987 DE 3742896
(43) Veröffentlichungstag der Anmeldung: 28.06.1989
(73) Patentinhaber: SIEMENS AKTIENGESELLSCHAFT, 80333 München (DE)
(72) Erfinder: Mühlbauer, Klaus-Dieter, Dipl.-Ing., D-8038 Gröbenzell (DE)

(56) Entgegenhaltungen:
- EP-A- 0 048 638
- US-A- 3 701 039
- US-A- 3 806 827
- US-A- 4 520 319
- IEEE GLOBAL TELECOMMUNICATIONS CONFERENCE, Band 1, 28. November - 1. Dezember 1983, San Diego, California, Seiten 447-455, IEEE, New York, US; H. MEYR et al.: "Synchronization design criteria for a token ring"
- NACHRICHTENTECHNIK ELEKTRONIK, Band 25, Nr. 8, 1975, Seiten 296-301, Berlin, DE; L. HARMS: "Wirkungsweise und Anwendung von Phasen- und Frequenzregelkreisen - eine Übersicht"

## Beschreibung

In der Telekommunikationstechnik besteht des öfteren die Aufgabe, einen Taktgenerator mittels eines sog. Taktregelkreises auf ein Digitalsignal zu synchronisieren, wobei die Frequenz dieses Digitalsignals gewissen Schwankungen unterliegen kann. Taktregelkreise sind als sog. Phasenregelkreise (Phase Locked Loop - PLL) und Frequenzregelkreise (Frequency Locked Loop - FLL) bekannt; sie bestehen im wesentlichen aus einem Phasen- und/oder Frequenzdetektor, (je) einem Filter und einem spannungsgesteuerten Taktoszillator (VCO), wobei der jeweilige Detektor auch mit zwei Ausgängen versehen sein kann, an dessen einem ein eine Taktfrequenzerhöhung bewirkendes up-Signal und an dessen anderem ein eine Taktfrequenzerniedrigung bewirkendes down-Signal auftreten kann (Nachrichtentechnik-Elektronik 25(1975)8, 296...301; Elektroniker (1978)3, EL32... EL37).

Bekannte Taktregelkreise haben die Eigenschaft, daß die Frequenzdetektor-Kennlinie Nulldurchgänge nicht nur bei der Sollfrequenz, sondern auch bei deren Harmonischen und Subharmonischen aufweist, was insbesondere dann zu einem Fehleinrasten führen kann, wenn es sich bei dem Digitalsignal, auf das der Taktgenerator zu synchronisieren ist, nicht ebenfalls um ein Taktsignal handelt, sondern um ein stochastisches (Nutz-)Signal; eine solche Problematik ergibt sich beispielsweise im Zusammenhang mit einer nach einer Übertragung eines Nutz-Digitalsignals vorzunehmenden Taktrückgewinnung mittels eines empfangsseitigen Taktregelkreises. Die Erfindung stellt sich die Aufgabe, einen auch einer solchen Problematik gerecht werdenden Frequenzdiskriminator anzugeben.

Die Erfindung betrifft einen Frequenzdiskriminator für einen digitalen Phasenregelkreis zur Synchronisierung eines mit einem Phasendiskriminator und einem Filter im Regelkreis liegenden, spannungsgesteuerten Taktgenerators auf ein Digitalsignal; dieser Frequenzdiskriminator ist erfindungsgemäß dadurch gekennzeichnet, daß eine Einzelbits des Digitalsignals ausblendende Bitausblendschaltung und eine einzelne Taktperioden des Taktsignals ausblendende Taktausblendschaltung vorgesehen sind, wobei jeweils bei Ausblendung eines Einzelbits durch die Bitausblendschaltung die Ausblendung einer Taktperiode durch die Taktausblendschaltung ausgelöst und ein der Differenz zwischen Bitdauer und Taktperiodendauer entsprechendes Frequenzregelkriterium (down - up) erzeugt wird.

Die Erfindung bringt den Vorteil mit sich, mit einer einfach zu integrierenden Diskriminatorschaltung einen Taktgenerator frequenzsicher auch auf ein stochastisches Digitalsignal synchronisieren zu können, da die Frequenzdiskriminator-Kennlinie einen Nulldurchgang lediglich bei der Digitalsignalfrequenz hat; das Digitalsignal kann dabei ggf. auch schon aus einem ursprünglichen höherfrequenten Digitalsignal mittels eines Frequenzteilers abgeleitet sein.

In weiterer Ausgestaltung der Erfindung können in der Bitausblendschaltung zwei jeweils über ein Verzögerungsglied mit zwischen dem Einfachen und dem Zweifachen der Bitdauer liegender Verzögerungszeit an ihrem Clock-Eingang mit dem nichtinvertierten bzw. invertierten Digitalsignal beaufschlagte bistabile D-Kippglieder vorgesehen sein,
- deren Ausgänge zu dem jeweils einen Eingang eines UND-Gliedes führen, dessen anderer Eingang mit dem um die genannte Verzögerungszeit zuzüglich einer der Signallaufzeit im bistabilen Kippglied entsprechenden zusätzlichen Verzögerungszeit verzögerten nichtinvertierten bzw. invertierten Digitalsignal beaufschlagt ist, und
- deren Komplementärausgänge zu dem jeweils einen Eingang eines UND-Gliedes führen, dessen anderer Eingang mit dem invertierten bzw. nichtinvertierten Digitalsignal beaufschlagt ist und das ausgangsseitig zum D-Eingang des jeweils anderen bistabilen Kippglieds führt,
wobei die Ausgänge der beiden erstgenannten UND-Glieder über ein ODER-Glied zusammengefaßt sind, dessen Ausgang den ein "down"-Frequenzregelsignal abgebenden Ausgang des Frequenzdiskriminators bildet; in der Taktausblendschaltung kann in weiterer Ausgestaltung der Erfindung ein vom Ausgang der Bitausblendschaltung her flankengesteuertes erstes bistabiles Kippglied vorgesehen sein, dessen Ausgang zum Eingang eines mit dem Taktsignal flankengesteuerten zweiten bistabilen Kippglieds führt, dessen Ausgang den ein "up"-Frequenzregelsignal abgebenden Ausgang des Fequenzdiskriminators bildet.

Weitere Besonderheiten der Erfindung werden aus der nachfolgenden näheren Erläuterung eines Ausführungsbeispiels anhand der Zeichnung ersichtlich. Dabei zeigt
- FIG 1: ein Ausführungsbeispiel eines Frequenzdiskriminators gemäß der Erfindung;
- FIG 2: zeigt darin auftretende Signalverläufe.

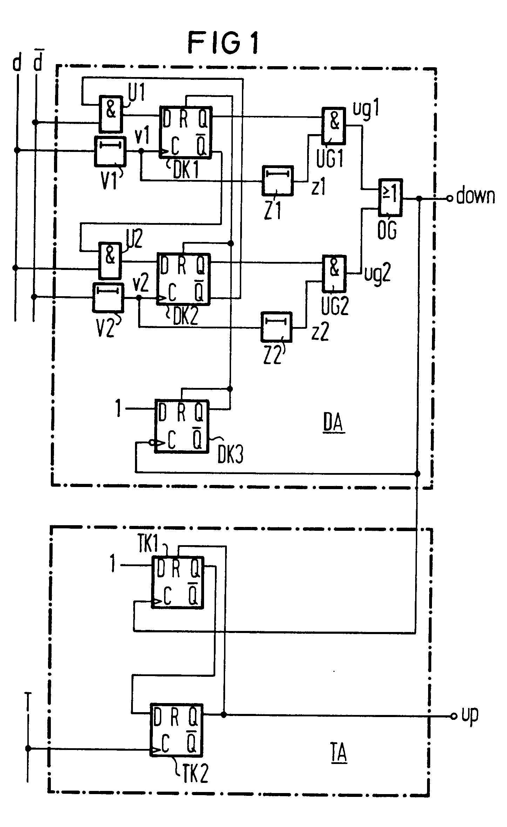

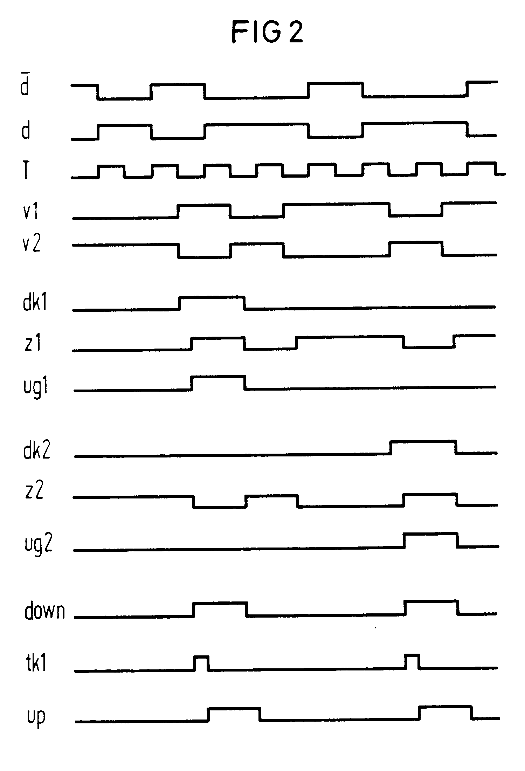

In dem in FIG 1 schematisch dargestellten Frequenzvergleicher ist zunächst einmal zur Ausblendung von Einzelbits eines auf einer Digitalsignalleitung d auftretenden Digitalsignals eine Bitausblendschaltung DA mit zwei bistabilen D-Kippgliedern DK1, DK2 vorgesehen, von denen das eine Kippglied DK1 über ein Verzögerungsglied V1 an seinem Clock-Eingang C mit dem nichtinvertierten Digitalsignal (d in FIG 2) beaufschlagt ist, während das andere Kippglied DK2 über ein Verzögerungsglied V2 an seinem Clock-Eingang C mit dem - gemäß FIG 1 auf einer Leitung d̅ auftretenden - invertierten Digitalsignal beaufschlagt wird. Die Verzögerungszeit der beiden Verzögerungsglieder V1, V2 möge zwischen dem Einfachen und dem Zweifachen der Bit-Nenndauer des Digitalsignals liegen.
Der Q-Ausgang des bistabilen Kippgliedes DK1 führt zu dem einen Eingang eines UND-Gliedes UG1, dessen anderer Eingang mit dem um die genannte Verzögerungszeit zuzüglich einer der Signallaufzeit im bistabilen Kippglied DK1 entsprechenden zusätzlichen Verzögerungszeit verzögerten nichtinvertierten Digitalsignal beaufschlagt ist. In entsprechender Weise führt der Q-Ausgang des bistabilen Kippgliedes DK2 zu dem einen Eingang eines UND-Glied UG2, dessen anderer Eingang mit dem in entsprechender Weise verzögerten invertierten Digitalsignal beaufschlagt ist. Die Komplementärausgänge Q̅ der beiden bistabilen Kippglieder DK1, DK2 führen zu dem jeweils einen Eingang eines UND-Gliedes U2 bzw. U1, dessen anderer Eingang mit dem invertierten bzw. nichtinvertierten Digitalsignal (d̅ bzw. d in FIG 2) beaufschlagt ist und das ausgangsseitig zu dem D-Eingang des jeweils anderen bistabilen Kippgliedes DK2 bzw. DK1 führt.
Die Ausgänge ug1, ug2 der beiden zuvor genannten UND-Glieder UG1, UG2 sind über ein ODER-Glied OG zusammengefaßt, dessen Ausgang den ein "down"-Frequenzregelsignal abgebenden Ausgang down des Frequenzdiskriminators bildet. Wie dies auch aus FIG 1 ersichtlich ist, können nach jeder Abgabe eines "down"-Signals die beiden bistabilen Kippglieder DK1, DK2 rückgesetzt werden, wozu an den Ausgang down ein flankengesteuertes weiteres bistabiles Kippglied DK3 angeschlossen sein kann, mit dessen Ausgang Q die Rücksetzeingänge R aller drei bistabiler Kippglieder DK1, DK2, DK3 verbunden sind.

Des weiteren weist der in FIG 1 skizzierte Frequenzvergleicher eine Taktausblendschaltung TA mit einem vom Ausgang down der Bitausblendschaltung DA her flankengesteuerten ersten bistabilen Kippglied TK1 auf, dessen Ausgang zum Eingang eines zweiten bistabilen Kippgliedes TK2 führt, das von dem auf einer Leitung T auftretenden Taktsignal (T in FIG 2) flankengesteuert wird und dessen Ausgang den ein "up"-Frequenzregelsignal abgebenden Ausgang up des Frequenzdiskriminators bildet. Wie dies auch aus FIG 1 ersichtlich ist, kann vom Ausgang up der Taktausblendschaltung TA her deren erstes bistabiles Kippglied TK1 bei jeder Abgabe eines "up"-Signals rückgesetzt werden, wozu der Rücksetzeingang R dieses Kippgliedes TK1 direkt mit dem Ausgang up der Taktausblendschaltung TA und zugleich des Frequenzdiskriminators verbunden sein kann.

Der in FIG 1 skizzierte Frequenzvergleicher arbeitet dann wie folgt.

Bei einem 0-1-Signalübergang des im Verzögerungsglied V1 verzögerten nichtinvertierten Digitalsignals (v1 in FIG 2) übernimmt das bistabile Kippglied DK1 das gerade auf der Leitung d̅ (in FIG 1) anstehende Bit des invertierten Digitalsignals (d̅ in FIG 2); ist dieses invertierte Bit ein "1"-Bit - und erweist sich somit das mit dem 0-1-Signalübergang des verzögerten nichtinvertierten Digitalsignals beginnende "1"-Bit als ein Einzelbit, d.h. als ein "1"-Bit, dem kein weiteres "1"-Bit unmittelbar vorangeht oder nachfolgt, - so wird dabei das bistabile Kippglied DK1 aktiviert, wie dies auch aus FIG 2, in Zeile dk1, ersichtlich wird.

In entsprechender Weise übernimmt bei einem 0-1-Signalübergang des im Verzögerungsglied V2 verzögerten invertierten Digitalsignals (v2 in FIG 2) das bistabile Kippglied DK2 das gerade auf der Leitung d (in FIG 1) anstehende Bit des nichtinvertierten Digitalsignals (d in FIG 2); ist dieses Bit ein "1"-Bit - und erweist sich somit das mit dem 0-1-Signalübergang des verzögerten invertierten Digitalsignals beginnende "1"-Bit als ein Einzelbit, d.h. als ein "1"-Bit, dem kein weiteres "1"-Bit unmittelbar vorangeht oder nachfolgt, - so wird dabei das bistabile Kippglied DK2 aktiviert, wie dies FIG 2 in Zeile dk 2 verdeutlicht.

Das gemäß FIG 1 in einem zusätzlichen Verzögerungsglied Z1 um eine oder einige wenige Gatterlaufzeiten (Signallaufzeiten im bistabilen Kippglied) zusätzlich verzögerte nichtinvertierte Digitalsignal gelangt zu dem einen Eingang des UND-Gliedes UG1, das für dieses nichtinvertierte Digitalsignal (z1 in FIG 2) vom bistabilen Kippglied DK1 her nur bei dessen Aktivierung entriegelt ist. Ein im Digitalsignal (d in FIG 2) enthaltenes einzelnes "1"-Bit tritt daher mit einer entsprechenden Verzögerung am Ausgang ug1 des UND-Gliedes UG1 auf, wie die auch FIG 2 in Zeile ug1 erkennen läßt.
In entsprechender Weise gelangt das gemäß FIG 1 in einem zusätzlichen Verzögerungsglied Z2 um eine oder einige wenige Gatterlaufzeiten (Signallaufzeiten im bistabilen Kippglied) zusätzlich verzögerte invertierte Digitalsignal (z2 in FIG 2) zu dem einen Eingang des UND-Gliedes UG2, das für dieses invertierte Digitalsignal vom bistabilen Kippglied DK2 her nur bei dessen Aktivierung entriegelt ist. Ein im invertierten Digitalsignal (d̅ in FIG 2) enthaltenes einzelnes "1"-Bit tritt daher mit einer entsprechenden Verzögerung am Ausgang ug2 des UND-Gliedes UG2 auf, wie dies auch FIG 2 in Zeile ug2 deutlich macht.
Die an den Ausgängen der beiden UND-Glieder UG1, UG2 auftretenden Einzelbits gelangen schließlich, über das ODER-Glied OG zusammengefaßt, zum Ausgang down der Bitausblendschaltung DA und zugleich des Frequenzdiskriminators, wie dies auch in der Zeile down in FIG 2 angedeutet ist. Dadurch, daß so sowohl Einzel-"1"-Bits als auch Einzel-"0"-Bits ausgeblendet werden, bleiben etwaige codebedingte Unterschiede in der Häufigkeit von "1"-Bits und "0"-Bits ohne Wirkung.

Das jeweils aktivierte bistabile Kippglied DK1 bzw. DK2 blockiert dabei das jeweils andere bistabile Kippglied (DK2 bzw. DK1) durch Sperrung des diesem Kippglied jeweils vorgeschalteten UND-Gliedes U2 bzw. U1, so daß auch von zwei unmittelbar aufeinanderfolgenden unterschiedlichen Einzelbits nur das jeweils erste Einzelbit ausgeblendet wird und somit eine Vortäuschung einer doppelten Bitdauer vermieden wird.

Jeweils mit dem Auftreten eines Einzelbits am Ausgang down des in FIG 1 skizzierten Frequenzdiskriminators wird das bistabile Kippglied DK3 gesetzt mit der Folge, daß vom Ausgang Q dieses bistabilen Kippgliedes DK3 her alle drei bistabilen Kippglieder DK1, DK2 und DK3 rückgesetzt werden.

Das am Ausgang down der Bitausblendschaltung DA und zugleich des Frequenzdiskriminators auftretende Digitalsignal-Einzelbit bildet unmittelbar das vom Frequenzdiskriminator angegebene "down"-Signal (down in FIG 2), das eine Herabsetzung der Taktfrequenz eines zu synchronisierenden Taktgenerators bewirkt, was hier jedoch nicht näher erläutert werden muß, da dies zum Verständnis der Erfindung nicht erforderlich ist.

Zugleich löst ein solches "down"-Signal aber auch die Ausblendung einer Taktperiode aus: Durch den 0-1-Signalübergang am Ausgang down wird das bistabile Kippglied TK1 der Taktausblendschaltung TA gesetzt (tk1 in FIG 2) mit der Folge, daß mit dem nachfolgenden 0-1-Signalübergang des auf der Leitung T auftretenden Taktsignals (T in FIG 2) auch das bistabile Kippglied TK2 aktiviert wird. Die Aktivierung des bistabilen Kippgliedes TK2 bewirkt unmittelbar die Rücksetzung des bistabilen Kippgliedes TK1, so daß die Aktivierung des bistabilen Kippgliedes TK2 gerade bis zum nächsten 0-1-Signalübergang des Taktsignals (T in FIG 2), d.h. exakt für eine Taktperiodendauer, andauert.

Ebendiese Dauer hat damit auch das am Ausgang up der Taktausblendschaltung TA und zugleich des Frequenzdiskriminators auftretende Taktperiodensignal (up in FIG 2); dieses Taktperiodensignal bildet unmittelbar das vom Frequenzdiskriminator abgegebene "up"-Signal, das eine Heraufsetzung der Taktfrequenz eines zu synchronisierenden Taktgenerators bewirkt, was hier jedoch nicht weiter erläutert werden muß, da dies zum Verständnis der Erfindung nicht erforderlich ist.

Wie man sieht, gibt der Frequenzdiskriminator also "down"-Signale von der Dauer gerade eines Digitalsignalbits und "up"-Signale von der Dauer gerade einer Taktperiode ab. Ist also die Bitzeitspanne länger als die Taktperiode (und ist damit die Digitalsignalfrequenz kleiner als die Taktfrequenz), so wird das "up"-Signal in seiner Dauer vom "down"-Signal überwogen, und man erhält durch Subtraktion des einen Signals von dem anderen Signal ein Differenzsignal, aus dem nach Tiefpaßfilterung ein Regelsignal hervorgeht, durch das die Taktfrequenz eines das Taktsignal (T in FIG 2) abgebenden Taktgenerators herabgesetzt und damit die Taktperiode entsprechend verlängert wird. Ist umgekehrt die Bitzeitspanne kürzer als die Taktperiode (und damit die Digitalsignalfrequenz größer als die Taktfrequenz), so wird das "down"-Signal in seiner Dauer vom "up"-Signal überwogen mit der Folge, daß in entsprechender Weise die Taktfrequenz erhöht und damit die Taktperiode entsprechend verkürzt wird. Sind Taktperiode und Bitzeitspanne gerade gleich lang, so heben sich "down"-Signal und "up"-Signal in ihrer Wirkung gerade auf; der Taktgenerator ist exakt auf das Digitalsignal synchronisiert.

## Patentansprüche

1. Frequenzdiskriminator für einen digitalen Phasenregelkreis zur Synchronisierung eines mit einem Phasendiskriminator und einem Filter im Regelkreis liegenden, spannungsgesteuerten Taktgenerators auf ein Digitalsignal,
**dadurch gekennzeichnet,**
daß eine Einzelbits des Digitalsignals (d) ausblendende Bitausblendschaltung (DA) und eine einzelne Taktperioden des Taktsignals (T) ausblendende Taktausblendschaltung (TA) vorgesehen sind, wobei jeweils bei Ausblendung eines Einzelbits durch die Bitausblendschaltung (DA) die Ausblendung einer Taktperiode durch die Taktausblendschaltung (TA) ausgelöst und ein der Differenz zwischen Bitdauer und Taktperiodendauer entsprechendes Frequenzregelkriterium (down - up) erzeugt wird.

2. Frequenzdiskriminator nach Anspruch 1,
**dadurch gekennzeichnet,**
daß in der Bitausblendschaltung (DA) zwei jeweils über ein Verzögerungsglied (V1, V2) mit zwischen dem Einfachen und dem Zweifachen der Bitdauer liegender Verzögerungszeit an ihrem Clock-Eingang (C) mit dem nichtinvertierten bzw. invertierten Digitalsignal (d; d̅) beaufschlagte bistabile D-Kippglieder (DK1, DK2) vorgesehen sind,
- deren Ausgänge (Q) zu dem jeweils einen Eingang eines UND-Gliedes (UG1 bzw. UG2) führen, dessen anderer Eingang mit dem um die genannte Verzögerungszeit zuzüglich einer der Signallaufzeit im bistabilen Kippglied (DK1 bzw. DK2) entsprechenden zusätzlichen Verzögerungszeit verzögerten nichtinvertierten bzw. invertierten Digitalsignal (d bzw. d̅) beaufschlagt ist, und
- deren Komplementärausgänge (Q̅) zu dem jeweils einen Eingang eines UND-Gliedes (U1 bzw. U2) führen, dessen anderer Eingang mit dem invertierten bzw. nichtinvertierten Digitalsignal (d̅ bzw. d) beaufschlagt ist und das ausgangsseitig zum D-Eingang des jeweils anderen bistabilen Kippglieds (DK2 bzw. DK1) führt,
wobei die Ausgänge der beiden erstgenannten UND-Glieder (UG1, UG2) über ein ODER-Glied (OG) zusammengefaßt sind, dessen Ausgang den ein "down"-Frequenzregelsignal abgebenden Ausgang (down) des Frequenzdiskriminators bildet.

3. Frequenzdiskriminator nach Anspruch 2,
**dadurch gekennzeichnet,**
daß von dem ein "down"-Frequenzregelsignal abgebenden Ausgang (down) des Frequenzdiskriminators her mit jeder Abgabe eines solchen "down"-Signals die beiden bistabilen D-Kippglieder (DK1, DK2) rückgesetzt werden.

4. Frequenzdiskriminator nach Anspruch 3,
**dadurch gekennzeichnet,**
daß an den Ausgang (down) ein flankengesteuertes weiteres bistabiles Kippglied (DK3) angeschlossen ist, mit dessen Ausgang (Q) die Rücksetzeingänge (R) ebendieses bistabilen Kippglieds (DK3) und der beiden zuvor genannten D-Kippglieder (DK1, DK2) verbunden sind.

5. Frequenzdiskriminator nach einem der Ansprüche 1 bis 4,
**dadurch gekennzeichnet,** daß in der Taktausblendschaltung (TA) ein vom Ausgang (down) der Bitausblendschaltung (DA) her flankengesteuertes erstes bistabiles Kippglied (TK1) vorgesehen ist, dessen Ausgang zum Eingang eines mit dem Taktsignal (T) flankengesteuerten zweiten bistabilen Kippglieds (TK2) führt, dessen Ausgang den ein "up"-Frequenzregelsignal abgebenden Ausgang (up) des Frequenzdiskriminators bildet.

6. Frequenzdiskriminator nach Anspruch 5,
**dadurch gekennzeichnet,**
daß von dem ein "up"-Frequenzregelsignal abgebenden Ausgang (up) des Frequenzdiskriminators her bei jeder Abgabe eines solchen "up"-Signals das erste bistabile Kippglied (TK1) rückgesetzt wird.

7. Frequenzdiskriminator nach Anspruch 6,
**dadurch gekennzeichnet,**
daß mit dem Ausgang "up" der Rücksetzeingang (R) des ersten bistabilen Kippglieds (TK1) direkt verbunden ist.

## Claims

1. Frequency discriminator for a digital phase-locked loop for synchronising a voltage-controlled clock generator arranged with a phase discriminator and a filter in a closed-loop control circuit with a digital signal, characterised in that a bit-gating circuit (DA) which gates individual bits of the digital signal (d) and a clock-gating circuit (TA) which gates individual clock periods of the clock signal (T) are provided, in which in each case when an individual bit is gated by the bit-gating circuit (DA), the gating of a clock period by the clock-gating circuit (TA) is triggered and a frequency control criterion (down - up) corresponding to the difference between bit duration and clock period duration is generated.

2. Frequency discriminator according to Claim 1, characterised in that there are provided in the bit-gating circuit (DA) two D-type bistable circuits (DK1, DK2) that receive at their clock input (C) the non-inverted and inverted digital signal (d; d̅) respectively in each case via a delay element (V1, V2) with a delay time of between one times and two times the bit duration,
- the outputs (Q) of which bistable circuits lead in each case to one input of an AND gate (UG1 and UG2 respectively), the other input of which receives the non-inverted or inverted digital signal (d or d̅ respectively) that is delayed by the aforesaid delay time plus an additional delay time corresponding to the signal propagation time in the bistable circuit (DK1 or DK2 respectively), and
- the complementary outputs (Q̅) of which bistable circuits lead in each case to one input of an AND gate (U1 and U2 respectively), the other input of which receives the inverted or non-inverted digital signal (d̅ or d respectively) and which leads on the output side to the D-input of the respective other bistable circuit (DK2 or DK1 respectively),
in which the outputs of the two first-mentioned AND gates (UG1, UG2) are combined by means of an OR gate (OG), the output of which forms the output (down) of the frequency discriminator outputting a "down" frequency control signal.

3. Frequency discriminator according to Claim 2, characterised in that the two D-type bistable circuits (DK1, DK2) are reset with each output of such a "down" signal from the output (down) of the frequency discriminator outputting a "down" frequency control signal.

4. Frequency discriminator according to Claim 3, characterised in that connected to the output (down) is an edge-controlled further bistable circuit (DK3), to the output (Q) of which the reset inputs (R) of this selfsame bistable circuit (DK3) and of the two aforesaid D-type circuits (DK1, DK2) are connected.

5. Frequency discriminator according to one of Claims 1 to 4, characterised in that there is provided in the clock-gating circuit (TA) a first bistable circuit (TK1) that is edge-controlled by the output (down) of the bit-gating circuit (DA), the output of which first bistable circuit leads to the input of a second bistable circuit (TK2) that is edge-controlled by the clock signal (T), the output of which second bistable circuit forms the output (up) of the frequency discriminator outputting an "up" frequency control signal.

6. Frequency discriminator according to Claim 5, characterised in that the first bistable circuit (TK1) is reset with each output of such an "up" signal from the output (up) of the frequency discriminator outputting an "up" frequency control signal.

7. Frequency discriminator according to Claim 6, characterised in that the reset input (R) of the first bistable circuit (TK1) is connected directly to the output "up".

## Revendications

1. Discriminateur de fréquence pour un circuit numérique de régulation de phase pour synchroniser, sur un signal numérique, un générateur de cadence commandé par la tension, qui est branché, ainsi qu'un discriminateur de phase et un filtre, dans le circuit de régulation, caractérisé par le fait
qu'il est prévu un circuit d'extraction de bits (DA), qui extrait des bits individuels du signal numérique (d), et un circuit d'extraction de la cadence (TA), qui extrait des périodes individuelles de cadence du signal de cadence (T) et que, respectivement, lors de l'extraction d'un bit individuel par le circuit d'extraction de bits (DA), l'extraction d'une période individuelle est déclenchée par le circuit d'extraction de la cadence (TA) et qu'un critère de régulation de fréquence (down-up), qui correspond à la différence entre la durée d'un bit et la durée d'une période de cadence, est formé.

2. Discriminateur de fréquence suivant la revendication 1, caractérisé par le fait
que dans le circuit d'extraction de bits (DA), il est prévu deux circuits à bascule bistable de type D, (DK1, DK2), qui sont chargés, au niveau de leur entrée de cadence (C) par le signal numérique non inversé et le signal numérique inversé (d;d̅), par l'intermédiaire de circuits respectifs de retardement (V1,V2) produisant des retards situés entre la durée d'un bit et le double de cette durée, et
- dont les sorties (Q) sont raccordées à une entrée respective d'un circuit ET, (UG1 ou UG2), dont l'autre entrée est chargée par le signal numérique non inversé ou inversé (d ou d̅) retardé du temps de retard indiqué plus un temps de retard supplémentaire qui correspond au temps de propagation des signaux dans le circuit à bascule bistable (DK1 ou DK2), et
- dont les sorties complémentaires (Q̅) aboutissent à une entrée respective d'un circuit ET, (U1 ou U2), dont l'autre entrée est chargée par le signal numérique inversé ou non inversé (d̅ ou d) et dont le côté sortie est raccordé à l'entrée D de l'autre circuit à bascule bistable respectif (DK1 ou DK2),
les sorties des deux circuits ET, (UG1, UG2), mentionnés en premier étant réunies par l'intermédiaire d'un circuit OU, (OG), dont la sortie forme la sortie (down), qui délivre un signal de régulation de fréquence "down", du discriminateur de fréquence.

3. Discriminateur de fréquence suivant la revendication 2, caractérisé par le fait
que les deux circuits à bascule bistable de type D, (DK1, DK2), sont ramenés à l'état initial à partir de la sortie (down), qui délivre un signal de régulation de fréquence "down", du discriminateur de fréquence, lors de chaque délivrance d'un tel signal "down".

4. Discriminateur de fréquence suivant la revendication 3, caractérisé par le fait
qu'à la sortie "down" est raccordé un autre étage à bascule bistable (DK3), commandé par les flancs des impulsions et à la sortie (Q) duquel sont raccordées les entrées de remise à l'état initial (R) de ce même circuit à bascule bistable (DK3) et des deux sorties à bascule bistable (DK1,DK2) mentionnées précédemment.

5. Discriminateur de fréquence suivant l'une des revendications 1 à 4, caractérisé par le fait
que dans le circuit d'extraction de cadence (TA), il est prévu un premier étage à bascule bistable (TK1), qui est commandé par les flancs des impulsions à partir du signal de sortie (down) du circuit d'extraction de bits (DA) et dont la sortie est raccordée à l'entrée d'un second étage à bascule bistable (TK2), qui est commandée par les flancs du signal de cadence (T) et dont la sortie forme une sortie (up), qui délivre un signal de régulation de fréquence "up", du discriminateur de fréquence.

6. Discriminateur de fréquence suivant la revendication 5, caractérisé par le fait
que le premier circuit à bascule bistable (TK1) est ramené à l'état initial à partir de la sortie (up), qui délivre un signal de régulation de fréquence "up", du discriminateur de fréquence, lors de chaque délivrance d'un tel signal "up".

7. Discriminateur de fréquence suivant la revendication 6, caractérisé par le fait
que l'entrée de remise à l'état initial (R) du premier circuit à bascule bistable (TK1) est raccordée directement à la sortie "up".
